(19) Europäisches Patentamt
European Patent Office
Office européen des brevets

(11) **EP 3 029 475 B1**

(12) **EUROPEAN PATENT SPECIFICATION**

(45) Date of publication and mention
of the grant of the patent:
**19.09.2018 Bulletin 2018/38**

(51) Int Cl.:
***G01R 31/08*** *(2006.01)* ***G01R 31/11*** *(2006.01)*

(21) Application number: **14841812.2**

(22) Date of filing: **03.09.2014**

(86) International application number:
**PCT/JP2014/004538**

(87) International publication number:
**WO 2015/033564 (12.03.2015 Gazette 2015/10)**

(54) **SINGULARITY LOCATION DEVICE**

SINGULARITÄTSAUFFINDUNGSVORRICHTUNG

DISPOSITIF DE LOCALISATION DE SINGULARITÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.09.2013 JP 2013183212**

(43) Date of publication of application:
**08.06.2016 Bulletin 2016/23**

(73) Proprietors:
• **Fujikura Ltd.**
**Tokyo 135-8512 (JP)**
• **Electric Power Development Co., Ltd.**
**Tokyo 104-8165 (JP)**

(72) Inventors:
• **KUMAMOTO, Yuji**
**Tokyo 104-8165 (JP)**

• **SHIBAYAMA, Keishi**
**Tokyo 104-8165 (JP)**
• **AMANO, Kazuo**
**Tokyo 135-8512 (JP)**

(74) Representative: **Hoffmann Eitle
Patent- und Rechtsanwälte PartmbB
Arabellastraße 30
81925 München (DE)**

(56) References cited:
**WO-A1-2007/080634      JP-A- H09 152 461
JP-A- S61 283 850      JP-A- 2004 012 291
JP-A- 2006 029 801      JP-A- 2006 029 801
US-A- 2 499 000      US-A- 6 097 331**

## Description

Technical Field

The present invention relates to a singularity locator, and more specifically, to a singularity locator using a scheme in which a singularity is located by comparing a transmission wave fed into a metal cable such as a transmission line used to transmit power with a reflected wave from the singularity.

Background Art

A pulse-radar-based fault locators referred to as a C type have been put to practical use (for example, NPTL 1) as apparatuses locating a fault and checking integrity of the transmission line. The fault is an example of a singularity in a transmission line resulting from cable disconnection or a lightning stroke.

A C-type fault locator installed at an end of a transmission line monitoring section is activated upon receiving information from a fault detection relay and the fault locator transmits a single AC pulse to the transmission line. Transmission of a pulse needs a time to charge a pulse transmitter of the fault locator, and thus fails to be repeated many times. The C-type fault locator observes a time from transmission of a pulse until reception of a reflected pulse reflected at a fault, and measures a distance to the fault based on the time (for example, NPTL 1).

Citation List

Patent Literature

JP 2006 029801 A relates to a cable damage detection method, a signal is transmitted to a cable and its reflected wave is measured to detect a damage of the cable. According to the method, a transmission signal of a time-varying frequency is inputted into the cable, a difference signal obtained by frequency-differencing a reflected signal from the cable and the transmission signal is stored, and the waveform of a difference signal stored in the initial stage is compared with the waveform of the difference signal at present. A damage in the cable is detected by using the size of the amount of change therebetween, or a change with time, or both of them.

JP H09 152461 A relates to a fault point locating apparatus. When a fault occurs in a power transmission line, a starting signal is applied to a control circuit from a fault detection relay. The control circuit sends an instruction to an impulse generator to transmit a high frequency impulse to the power transmission line. After a reflected wave from the power transmission line is set to a specified level by a voltage division circuit, it undergoes an A/D conversion with an A/D converter as intact. An output signal of the A/D converter is stored on memory devices. The location of a fault point is performed from an energy difference between the reflected wave in the normal time and the reflected wave in case of the fault.

Non-Patent Literature

NPTL 1: Electric Technology Research Association "Electrical Joint Research, Vol. 34, No. 6, Measures for Improving Fault Locator Location Reliability", Electric Technology Research Association Publishing, February 28, 1979, pp. 7, 8, 60, 62

Summary of Invention

However, for the conventional C-type fault locators, when a transmission wave with a central frequency of 400 kHz is used, disadvantageously a transmission wave and a reflected wave fail to be discriminated from each other for a near end at a distance of approximately 2 km or shorter that is a section corresponding to a time of approximately 13 $\mu$s. Thus, there is a problem of disabling location determination (for example, NPTL 1).

Thus, an object of the present invention is to provide a singularity locator that enables a singularity such as a fault to be located even in a near-end section. The object of the invention is achieved by the subject-matter of the independent claims. Advantageous embodiments are defined in the dependent claims. Further examples are provided for facilitating the understanding of the invention.

One example of the present invention is a singularity locator that locates a singularity by comparing a transmission wave with a reflected wave of the transmission wave reflected at the singularity at which impedance changes, characterized in that, the transmission wave is a frequency modulated continuous-wave (FMCW) with a continuously modulated frequency, and the singularity is located based on a difference in frequency between the transmission wave and the reflected wave.

The present invention can provide a singularity locator that enables a singularity to be located even in a near-end section.

Brief Description of Drawings

[Fig. 1] Fig. 1 is a diagram depicting conceptual blocks of a fault locator in an embodiment of the present invention;
[Fig. 2] Fig. 2 is a diagram illustrating an operational principle for the fault locator in the embodiment of the present invention;
[Fig. 3A] Fig. 3A is a diagram illustrating an operational principle of a method for deriving the location of a fault in the embodiment of the present invention;
[Fig. 3B] Fig. 3B is a diagram illustrating the operational principle of the method for deriving the location of a fault in the embodiment of the present invention;
[Fig. 3C] Fig. 3C is a diagram illustrating the operational principle of the method for deriving the location of a fault in the embodiment of the present invention;
[Fig. 3D] Fig. 3D is a diagram illustrating the operational principle of the method for deriving the location of a fault in the embodiment of the present invention; and
[Fig. 4] Fig. 4 is a diagram illustrating the operational principle of the method for deriving the location of a fault in the embodiment of the present invention.

Description of Embodiments

Before description of an embodiment of the present invention, problems other than the above-described technical problem with the conventional C-type fault locators that locate a fault that is an example of a singularity.
The C-type fault locator has a high transmission pulse voltage of 2 to 3 kV and needs a charging time for a capacitor, thus failing to consecutively transmit pulses in a short time. This makes improvement of location determination accuracy of the C-type fault locator difficult (a constraint on location determination process time associated with pulse radar-based apparatuses)
The C-type fault locator has a high transmission pulse voltage of 2 to 3 kV and has difficulty incorporating semiconductors in connection with components used for an impulse generator and electrical design and insulation design. This makes downsizing the C-type fault locator difficult (a constraint on downsizing by a high transmission pulse voltage)
In a lower phase of long-distance transmission lines and untransposed multiconductor transmission lines, a high-frequency impulse suffers a large transmission loss, making long-distance location determination difficult. NPTL 1 reports that the C-type fault locator may have a locatable distance of approximately 40 km (a constraint on location determination in a transmission line with a large transmission loss).
If ice or snow accretion occurs on an overhead transmission line, the transmission loss in high-frequency impulse increases exponentially in proportion to frequency. This may reduce location determination accuracy or make location determination difficult (a decrease in location determination accuracy resulting from ice or snow accretion) .
The C-type fault locator fails to monitor the state of transmission lines. Furthermore, some apparatuses detect an abnormality occurring in a line by monitoring the level of a communication frequency using another scheme, but fail to determine the location of the abnormality.
The embodiment of the present invention that solve these problems will be described below in detail with reference to the drawings.

(Embodiment 1)

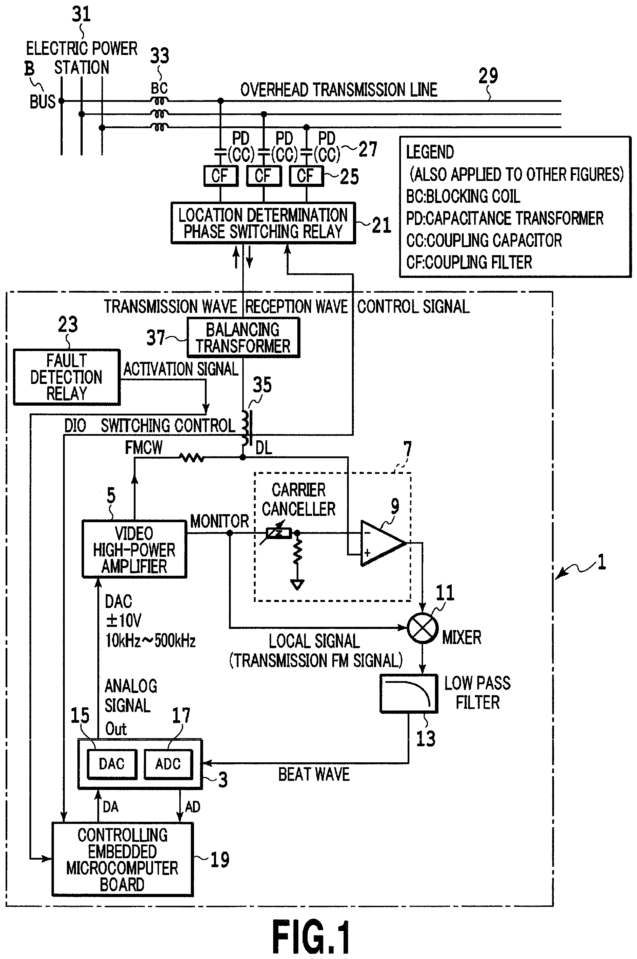

Fig. 1 is a fault locator in Embodiment 1 of the present invention. A fault locator 1 in the present embodiment includes a converter 3, a video high-power amplifier 5, a carrier canceller 7, a differential amplifier 9, a mixer 11, and a low-frequency-band pass filter (low pass filter) 13.
The converter 3 includes a digital-analog converter (DAC) 15 that converts a digital signal into an analog signal and an analog-digital converter (ADC) 17 that converts an analog signal into a digital signal. The converter 3 is controlled by a controlling embedded microcomputer board (a circuit board on which a microcomputer is mounted) 19.
The DAC 15 included in the converter 3 is connected to the video high-power amplifier 5 to convert a digital signal transmitted from the controlling embedded microcomputer board 19 into an analog signal, and transmits the resultant analog signal to the video high-power amplifier 5.
The video high-power amplifier 5 is connected to the carrier canceller 7, a + input terminal of the differential amplifier 9, and the mixer 11 to generate a frequency modulated continuous-wave (FMCW) from the analog signal received from the DAC 15 in the converter 3.

The carrier canceller 7 is connected to one input terminal of the differential amplifier 9. An output terminal of the differential amplifier 9 is connected to the mixer 11. The carrier canceller 7 and the differential amplifier 9 form a canceller circuit.

The mixer 11 is an analog multiplier that is a circuit outputting, upon receiving signals with two different frequencies, for example, $f_1$ and $f_2$, a signal with a frequency $f_1 \pm f_2$ corresponding to the sum of the two frequencies and the difference between the frequencies in accordance with the principal of heterodyne. Here, "the principal of heterodyne" refers to the possibility of observing, when two waves with slightly different frequencies are superimposed on each other, a beat wave (beat) equal to the difference between the frequencies. The mixer 11 is connected to the low pass filter 13 to multiply a transmission FM signal received from the video high-power amplifier 5 with a reception FM signal received from the differential amplifier 9 to generate a beat signal. The mixer 11 then transmits the beat signal to the low pass filter 13.

The low pass filter 13 is connected to the ADC 17 included in the converter 3 to transmit the beat signal received from the mixer 11 and from which a high-frequency component has been removed, to the ADC 17.

The ADC 17 converts the beat signal received from the low pass filter 13 into a digital signal, and transmits the resultant digital signal to the controlling embedded microcomputer board 19.

A location determination phase switching relay 21 and a fault detection relay 23 are connected to the controlling embedded microcomputer board 19.

The location determination phase switching relay 21 is connected to, for example, 3-phase AC overhead transmission line 29 via a coupling filter (CF) 25 and a capacitance transformer (PD) 27. Moreover, the location determination phase switching relay 21 is connected to the video high-power amplifier 5 and the differential amplifier 9 via a delay element (DL) 35 and a balancing transformer 37. The location determination phase switching relay 21 receives a switching control signal for a location determination phase from the controlling embedded microcomputer board 19 and receives a transmission FM signal that is a transmission wave from the video high-power amplifier 5. Furthermore, the location determination phase switching relay 21 transmits a reception FM signal that is a reception wave to the differential amplifier 9.

The capacitance transformer (PD) 27 is a power equipment or an electric component in an existing facility in an electric power station 31 that converts the magnitude of a voltage of AC power utilizing electromagnetic induction. The capacitance transformer (PD) 27 converts a high, primary voltage into a measureble secondary voltage by dividing the primary voltage. The delay element (DL) 35 can be used to allow a beat wave to be easily detected in the transmission wave and the reception wave when the distance between the location determination phase switching relay 21 and the fault locator 1.

The overhead transmission line 29 is connected to a bus B in the electric power station 31, and a blocking coil (BC) 33 is provided on the overhead transmission line 29. A coupling capacitor (CC) may be used as the capacitance transformer (PD) 27, and the overhead transmission line 29 may be a DC transmission line. For the DC transmission line, the overhead transmission line 29 includes two and two main lines and two return lines, a total of four lines.

The fault detection relay 23, upon detecting a fault in the overhead transmission line 29, transmits an activation signal to the controlling embedded microcomputer board 19. The fault locator 1 may include a semiconductor storage device that pre-stores the FMCW.

The balancing transformer 37 is a transformer on the fault locator 1 side that enables even a cable with a non-equilibrium impedance to be measured. This allows a fault to be detected even in a combination of transmission lines included in the plurality of transmission lines.

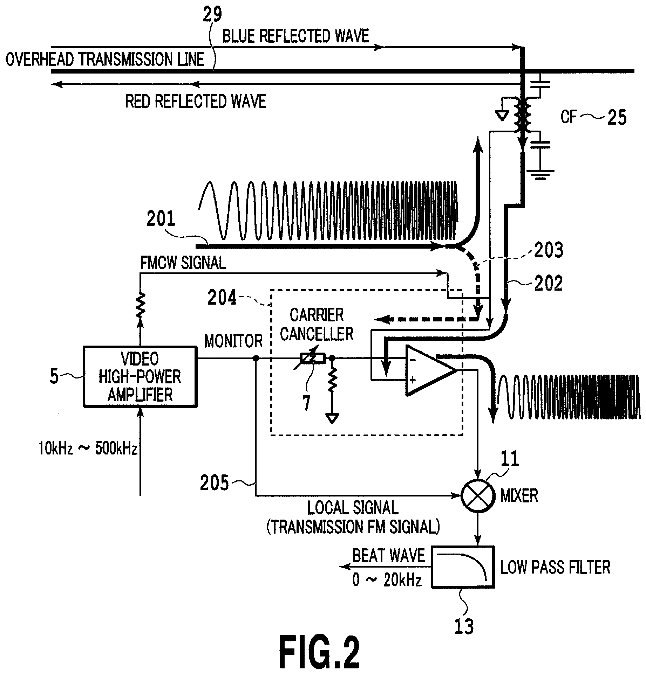

Fig. 2 is a diagram illustrating an operational principle for the fault locator in the present embodiment. Using Fig. 2, an operation of the fault locator 1 will be described in which a beat signal.

First, the video high-power amplifier 5 generates a frequency modulated continuous-wave (FMCW) from an analog signal received from the DAC 15 in the converter 3, and outputs the FMCW to the overhead transmission line 29 as a transmission wave (thick line 201). The FMCW flows through the overhead transmission line 29 via the CF 25.

The FMCW, which is a transmission wave flowing through the overhead transmission line 29, becomes a reflected wave at a location where the impedance of the overhead transmission line 29 changes (a fault). The reception wave, which is a reflected wave, flows along the path through which the transmission wave has flowed, in a direction opposite to the direction of the transmission wave, from the overhead transmission line 29 toward the canceller circuit via the CF 25 (thick line 202). At this time, the reception wave, compared to the transmission wave, has a reduced amplitude and a delayed period.

On the other hand, the FMCW generated by the video high-power amplifier 5 is output to the differential amplifier 9 in the canceller circuit as a transmission wave (dashed line 203). Therefore, the FMCW generated by the video high-power amplifier 5 is output to the carrier canceller 7 in the canceller circuit 204. The canceller circuit 204 cancels the transmission wave and outputs only the reception wave through the differential amplifier 9. The canceller circuit 204 in the present embodiment conventionally includes a hybrid circuit or a circulator circuit.

The mixer 11 receives a signal with the reception wave output from the differential amplifier 9 and a local signal (transmission FM signal) with the same waveform as that of the transmission wave received directly from the video high-power amplifier 5 (segment 205).

The mixer 11 superimposes sine waves of the transmission wave and the reception wave on each other to generate a beat wave. The generated beat wave is detected so as to allow generation of a beat signal that enables a fault to be detected in the beat wave. A scheme adopted for this detection is product detection that is known as the most efficient scheme.

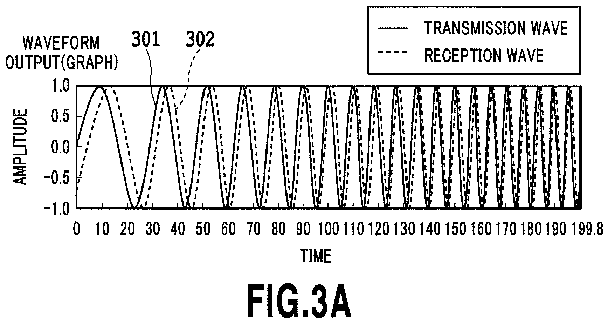

Figs. 3A to 3D are diagrams illustrating a fault detection scheme in the fault locator 1 in the present embodiment. Using Figs. 3A to 3D, a fault detection method utilizing the FMCW in the present embodiment will be described.

Fig. 3A depicts schematic waveforms of a transmission wave 301 transmitted from the video high-power amplifier 5 to the overhead transmission line 29 and a reception wave 302 resulting from reflection of the transmission wave 301 at a fault in the overhead transmission line 29 and received by the differential amplifier 9. The axis of ordinate represents the amplitudes of the waves. The axis of abscissas represents time. Compared to the transmission wave 301, the reception wave 302 is delayed by an amount equal to a time needed for an electric wave to propagate through the overhead transmission line 29 and has a frequency shifted by an amount equivalent to the delayed arrival time.

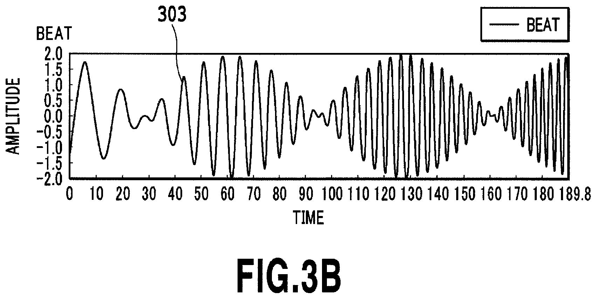

Fig. 3B is a schematic waveform resulting from synthesis of the transmission wave 301 and the reception wave 302 by the mixer 302. As is the case with Fig. 3A, the axis of ordinate represents the amplitudes of the waves, and the axis of abscissas represents time. However, the time axis is longer than the time axis in Fig. 3A. The synthesis of the waves with the two different frequencies results in a beat wave (beat) 303.

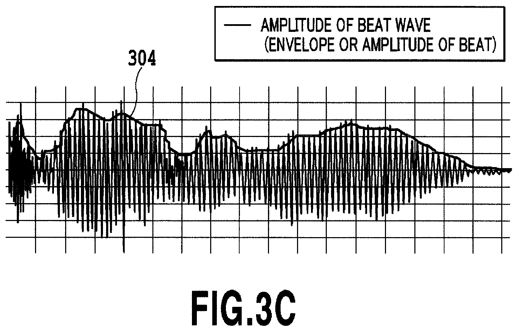

Fig. 3C depicts an envelope 304 that joins the peaks of the amplitude of the beat wave 303 (the amplitude of the beat) at points of time together with a line. As is the case with Fig. 3B, the axis of ordinate represents the amplitudes of the waves, and the axis of abscissas represents time.

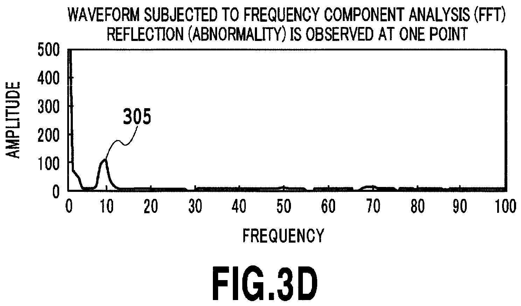

Fig. 3D depicts a result of frequency component analysis executed on the beat wave 303 based on Fourier transform (FFT) . A location (peak point 305) that corresponds to a fault where reflection occurs, with a frequency component changed is presented. In Fig. 3D, the axis of ordinate represents the amplitude of the wave, and the axis of abscissas represents the frequency of the wave.

Now, a method for detecting a fault location utilizing the FMCW scheme will be described.

First, the video high-power amplifier 5 transmits the transmission wave 301, which is an FMCW, to the overhead transmission line 29. A reflected wave (echo) of the transmitted FMCW is received by the differential amplifier 9. The transmission wave 301 and the reception wave 302 are synthesized into the beat wave 303 by the mixer (Fig. 3B). The low pass filter 13 extracts the envelope 304 representing the amplitude of the beat wave 303 (Fig. 3C). The controlling embedded microcomputer board 19 executes frequency component analysis (FFT) on the extracted envelope 304 (Fig. 3D). Based on changes in impedances, a point is detected where a frequency component resulting from the reflection at the fault has changed significantly (Fig. 3D). The location of the fault is derived from the frequency of the point where the frequency component has changed significantly. A method for deriving the location of the fault will be described below.

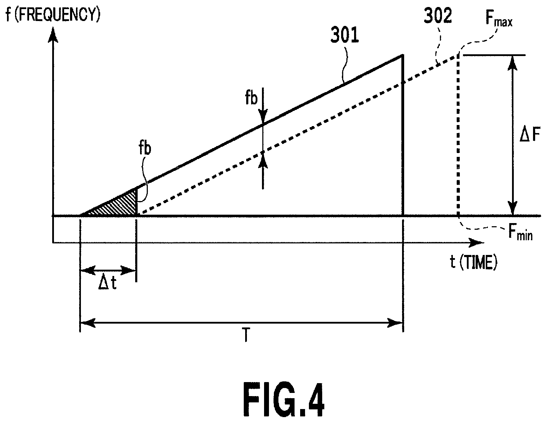

Fig. 4 is a diagram illustrating a method for deriving the location of the fault utilizing the FMCW scheme in the present embodiment. In Fig. 4, the axis of ordinate represents a frequency F, and the axis of abscissas represents a time t. Furthermore, in Fig. 4, a sweep frequency (the frequency of the transmission wave 301 changed at a constant period) is denoted by $\Delta F$. A sweep time is denoted by T. A sweep rate is denoted by k. The frequency of the beat wave (the difference in frequency between the transmission wave 301 and the reception wave 302) is denoted by fb. A delay time in the reflected wave is denoted by $\Delta t$. A propagation speed is denoted by c. A distance to the reflection point (fault) is denoted by X.

In Fig. 4, based on the similarity between triangles, Expression (1) is given.

$$\Delta F/T \;=\; fb/\Delta \;\;.\;.\;.\;\;(1)$$

Expression (1) is transformed as follows.

$$\Delta T \;=\; (T \cdot fb)/\Delta F \;\;.\;.\;.\;\;(1)'$$

A reciprocating distance 2X from a measurement point to a fault is expressed as follows.

$$2X \;=\; c \cdot \Delta t \;\;.\;.\;.\;\;(2)$$

Thus, Expression (1)' is substituted into Expression (2).

$$2X = c \cdot (T \cdot fb)/\Delta F \ldots (2)'$$

Expression (2)' is transformed as follows.

$$X = \{(T \cdot c)/(\Delta F \cdot 2)\} \cdot fb \ldots (3)$$

Here, $\Delta F/T$ is a sweep rate k and is substituted into Expression (3).

$$X = \{c/(2k)\} \cdot fb \ldots (3)'$$

Therefore, since the sweep rate k (= $\Delta F/T$) and the propagation distance c are known, determining the frequency fb of the beat wave allows the distance X to the fault to be determined in accordance with Expression (3)'.

In the present embodiment, the intensity of the beat wave (beat) between the transmission wave, which is a frequency modulated continuous-wave (FMCW), and the reflected wave of the transmission wave corresponds to a change in surge impedance. Executing Fourier transform on the beat wave allows the peak point of a waveform representing changing points in surge impedance to be a fault. The FMCW is conventionally used by a meteorological radar for transmission into the air. Furthermore, in common technical knowledge in the field of the invention, the FMCW is considered to be able to be used only in a high frequency band such as a Giga Hertz band and to be unable to be used for individuals due to high attenuation. However, when the FMCW was actually applied as a transmission wave fed into the overhead transmission line, location determination of faults was found to be possible.

Here, a method for deriving the locatable shortest distance in the present embodiment is illustrated below.

First, when a minimum beat frequency is denoted by fbmin, the propagation speed is denoted by c, and the sweep rate is denoted by k, the locatbale shortest distance Lmin is expressed as follows.

$$Lmin = (fbmin \cdot c)/(2 \cdot k) \ldots (4)$$

When a line length is denoted by L and the sweep time is denoted by T, the minimum beat frequency fbmin is expressed as follows.

$$Fbmin = 1/\{T - (2 \cdot L/c)\} \ldots (5)$$

The reciprocating time ($2 \cdot L/c$) corresponds to a delay time $\Delta t$ in the reflected wave. When the sweep frequency is denoted by $\Delta F$ (= Fmax - Fmin), the sweep rate is expressed as follows.

$$k = \Delta F/T = (Fmax - Fmin)/T \ldots (6)$$

Hence, substitutingExpression (5) and Expression (6) into Expression (4) allows the locatable shortest distance Lmin to be expressed as follows.

$$Lmin = (c \cdot T)/[2 \cdot \{T - (2 \cdot L/c)\} \cdot (Fmax - Fmin)] \ldots (7)$$

In a specific example, when the line length is 26.95 km, the sweep frequency is 170 kHz to 450 kHz, and the sweep time is 10 ms, the locatable shortest distance is 545 m in accordance with Expression (7).

Therefore, effects described below can be produced by applying the FMCW to the fault locator 1 and sweeping the frequency in a usable frequency band. That is, near-end unlocatable sections with respect to the fault locator 1 can be reduced. Furthermore, distance resolution is improved, and enhanced detection sensitivity allows location determination to be performed on a transmission line with a large transmission loss. Furthermore, detection of impedance changing points is enabled, allowing the state of lines to be monitored.

The FMCW in the present embodiment allows location determination to be performed using a low transmission wave voltage, eliminating the need to charge a capacitor. This enables the whole apparatus component circuit to be configured using semiconductors, allowing the fault locator to be miniaturized.

Moreover, when the whole apparatus component circuit is configured using semiconductors, wavelength occurrence intervals can be shortened, and a waveform processing section is allowed to have many functions. Thus, location determination accuracy and reliability can be improved.

The fault locator 1 to which the FMCW according to the present embodiment is applied can be used, for example, to locate a fault in an aerial portion of a DC transmission line. The fault locator 1 in the present embodiment is not limited to overhead transmission lines but may be used to locate faults in metal cables such as electric wires and coaxial cables.

**Claims**

1. A singularity locator (1) connected to an input/output point in one overhead transmission line (29) via a coupling filter (25) and a capacitance transformer (27), wherein :

    a FMCW generation generator for generating a frequency modulated continuous-wave (FMCW) with a continuously modulated frequency as a transmission wave and inputting the transmission wave toward the input/output point via the coupling filter and the capacitance transformer;

    a carrier canceller circuit (7) for receiving a reflected wave outputted from the input/output point via the coupling filter and the capacitance transformer and
    canceling out the transmission wave component using an FMCW divided from the FMCW generator from the reflected wave, wherein the transmission wave propagates the one overhead transmission line, is reflected at a singularity at which the impedance changes, propagates the one overhead transmission line in an opposite direction and is outputted from the input/output point as the reflected wave;

    a mixer (11) for generating a beat wave from a difference in frequency between the FMCW divided from the FMCW generator and the reflected wave;

    a low pass filter (13) for extracting a low frequency component from the beat wave; and

    a microcomputer (19) for locating the singularity of the one overhead transmission line by executing Fourier transform on the low frequency component of the of the beat wave.

2. The singularity locator (1) according to claim 1, **characterized by** comprising a balancing transformer (37) connected to the input/output point for performing balanced/ unbalanced conversion.

3. The singularity locator according to claim 1, **characterized by** comprising:

    a semiconductor storage for pre-storing waveform data of the FMCW; and
    a digital-analog converter (15) for converting a digital signal into an analog signal,
    wherein the microcomputer receives the waveform data of the FMCW from the semiconductor storage and sends to the digital-analog converter (15) so that the digital-analog convertor outputs the transmission wave of the FMCW.

**Patentansprüche**

1. Singularitätslokalisierer (1), der an eine Eingangs-/Ausgangsstelle in einer oberirdischen Übertragungsleitung (29) über ein Kopplungsfilter (25) und einen kapazitiven Transformator (27) angeschlossen ist, wobei:

    ein FMCW-Erzeugungsgenerator zum Erzeugen einer frequenzmodulierten kontinuierlichen Welle (FMCW) mit einer kontinuierlich modulierten Frequenz als eine Übertragungswelle und Eingeben der Übertragungswelle in die Eingangs-/Ausgangsstelle über das Kopplungsfilter und den kapazitiven Transformator;

    eine Trägerbeseitigungsschaltung (7) zum Empfangen einer reflektierten Welle, die von der Eingangs-/Ausgangsstelle über das Kopplungsfilter und den kapazitiven Transformator ausgegeben wird, und
    Beseitigen der Übertragungswellenkomponente mit der Verwendung einer FMCW, die von dem FMCW-Generator geteilt wird, aus der reflektierten Welle, wobei sich die Übertragungswelle durch die eine oberirdische Übertragungsleitung ausbreitet, bei einer Singularität reflektiert wird, bei welcher sich die Impedanz ändert, sich durch die eine oberirdische Übertragungsleitung in einer Gegenrichtung ausbreitet und von der Eingangs-/Ausgangsstelle als die reflektierte Welle ausgegeben wird;

ein Mischer (11) zum Erzeugen einer Schwebungswelle aus einem Frequenzunterschied zwischen der FMCW, die von dem FMCW-Generator geteilt wird, und der reflektierten Welle; und

ein Tiefpassfilter (13) zum Extrahieren einer niederfrequenten Komponente aus der Schwebungswelle; und

ein Mikrocomputer (19) zum Lokalisieren der Singularität der einen oberirdischen Übertragungsleitung durch Ausführen einer Fouriertransformation an der niederfrequenten Komponente der Schwebungswelle.

2. Singularitätslokalisierer (1) nach Anspruch 1, **dadurch gekennzeichnet, dass** er einen an die Eingangs-/Ausgangsstelle angeschlossenen Ausgleichstransformator (37) zum Durchführen einer ausgeglichenen/unausgeglichenen Wandlung umfasst.

3. Singularitätslokalisierer nach Anspruch 1, **dadurch gekennzeichnet, dass** er Folgendes umfasst:

einen Halbleiterspeicher zum Vorspeichern von Wellenformdaten der FMCW; und

einen Digital-Analog-Wandler (15) zum Wandeln eines digitalen Signals in ein analoges Signal, wobei der Mikrocomputer die Wellenformdaten der FMCW von dem Halbleiterspeicher empfängt und zu dem Digital-Analog-Wandler (15) sendet, so dass der Digital-Analog-Wandler die Übertragungswelle der FMCW ausgibt.

**Revendications**

1. Dispositif de localisation de singularité (1) relié à un point d'entrée / sortie dans une ligne de transmission aérienne (29) via un filtre de couplage (25) et un transformateur de capacité (27), dans lequel :

un générateur de production FMCW pour produire une onde continue à fréquence modulée (FMCW) avec une fréquence continuellement modulée en tant qu'onde de transmission et pour entrer l'onde de transmission vers le point d'entrée / sortie via le filtre de couplage et le transformateur de capacité ;

un circuit de dispositif d'annulation de porteuse (7) pour recevoir une onde réfléchie sortie en provenance du point d'entrée / sortie via le filtre de couplage et le transformateur de capacité, et l'annulation de la composante d'onde de transmission en utilisant une FMCW divisée en provenance du générateur FMCW à partir de l'onde réfléchie, dans lequel l'onde de transmission se propage sur la ligne particulière de transmission aérienne, est réfléchie au niveau d'une singularité au niveau de laquelle l'impédance change, se propage sur la ligne particulière de transmission aérienne dans un sens opposé et est sortie depuis le point d'entrée / sortie en tant qu'onde réfléchie ;

un mélangeur (11) pour produire une onde de battement à partir d'une différence de fréquence entre la FMCW divisée en provenance du générateur FMCW et l'onde réfléchie ;

un filtre passe-bas (13) pour extraire une composante de basse fréquence à partir de l'onde de battement ; et

un micro-ordinateur (19) pour localiser la singularité de la ligne particulière de transmission aérienne en exécutant une transformée de Fourier sur la composante de basse fréquence de l'onde de battement.

2. Dispositif de localisation de singularité (1) selon la revendication 1, **caractérisé en ce qu'**il comprend un transformateur d'équilibrage (37) relié au point d'entrée / sortie pour effectuer une transformation équilibrée / non équilibrée.

3. Dispositif de localisation de singularité selon la revendication 1, **caractérisé en ce qu'**il comprend :

une mémoire à semi-conducteurs pour stocker à l'avance des données de forme d'onde de la FMCW; et

un convertisseur numérique-analogique (15) pour transformer un signal numérique en un signal analogique, dans lequel le micro-ordinateur reçoit les données de forme d'onde de la FMCW en provenance de la mémoire à semi-conducteurs et envoie au convertisseur numérique-analogique (15) de sorte que le convertisseur numérique-analogique sort l'onde de transmission de la FMCW.

**FIG.1**

**FIG.2**

FIG.3A

FIG.3B

FIG.3C

WAVEFORM SUBJECTED TO FREQUENCY COMPONENT ANALYSIS (FFT)
REFLECTION (ABNORMALITY) IS OBSERVED AT ONE POINT

FIG.3D

**FIG.4**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006029801 A

- JP H09152461 A

### Non-patent literature cited in the description

- Measures for Improving Fault Locator Location Reliability. Electrical Joint Research. Electric Technology Research Association Publishing, 28 February 1979, vol. 34, 7, , 8, , 60, , 62